# DEMANDE DE BREVET EUROPEEN

(11) **EP 0 736 906 A1**
(43) Date de publication de la demande: **09.10.1996**
(21) Numéro de dépôt: 96400718.1
(22) Date de dépôt: 03.04.1996
(51) Int. Cl.: H01L 27/144, H01L 27/146

(54) **Composant optique de démultiplexage temporel**

(30) Priorité: 05.04.1995 FR 9504032
(71) Demandeur: FRANCE TELECOM, 75015 Paris (FR)
(72) Inventeur: Souli, Nabil, 94200 Ivry / Seine (FR); Vandamme, Patrick, 22700 Perros Guirec (FR); Thomine, Jean-Baptiste, 75014 Paris (FR)
(74) Mandataire: Martin, Jean-Jacques

(57) **Abrégé**

Composant optique pour le démultiplexage temporel de trains d'impulsions optiques, présentant une structure (7) à multipuits quantiques et des moyens (10, 11) pour appliquer à une section (1) de cette structure (7) à multipuits quantiques une tension pour la commande de cette section comme porte optique de démultiplexage, caractérisé en ce qu'il comporte également des moyens (10, 11) pour appliquer une tension de polarisation à une autre section (3) de cette structure (7) à multipuits quantiques, cette section (3) étant située sur le trajet des impulsions optiques en aval de la section utilisée comme porte optique, ces moyens de polarisation (10, 11) permettant de recueillir le photocourant généré par les impulsions optiques reçues par cette deuxième section (3), qui sert ainsi de photo-récepteur.

## Description

La présente invention est relative à un composant optique de démultiplexage temporel.

Elle trouve en particulier avantageusement application pour le démultiplexage temporel d'impulsions à haut débit, notamment d'impulsions de type solitons.

Il a déjà été proposé d'utiliser des modulateurs électro-absorbants à structure à puits quantiques comme portes optiques de démultiplexage.

On pourra à cet égard avantageusement se référer à l'article suivant :
Suzuki et al, "New application of a sinusoidally driven InGaAsP Electroabsorption Modulator to In-Line optical Gates, with ASE noise reduction effect" - (Journal of Lightwave Technology, Vol. 10, n°12, p. 1912-1917, Décembre 1992).

Le démultiplexage optique temporel à l'aide de modulateurs électroabsorbants présente au moins deux avantages.

Il permet de détecter des trains d'impulsions optiques transmis à des débits supérieurs aux vitesses maximales de fonctionnement des bascules de décision électroniques (jusqu'à 20 GHz ou plus).

Egalement, il permet, dans le cas d'impulsions optiques guidées, une plus grande tolérance vis-à-vis des phénomènes de gigue (fluctuations des temps d'arrivée des bits).

Jusqu'à présent, dans un montage de réception, les sorties des modulateurs électro-absorbants utilisés comme démultiplexeurs temporels étaient couplées à des fibres optiques par lesquelles les impulsions en sortie des modulateurs étaient envoyées sur des diodes de réception.

Par exemple, dans le montage de démultiplexage décrit dans l'article précité de Suzuki et al., la totalité du codage porté par un train d'impulsions solitons est récupérée en superposant les signaux reçus par deux photodiodes en sortie de deux modulateurs électro-absorbants commandés avec un déphasage dans le temps correspondant à un bit de réception.

Une telle structure présente toutefois l'inconvénient majeur d'être d'un encombrement important.

Par ailleurs, son fibrage optique la rend fort onéreuse.

Notamment, le fibrage optique pose des problèmes de couplage avec les modulateurs électro-absorbants et les photodiodes.

La présente invention propose quant à elle un composant de démultiplexage optique temporel permettant de pallier ces différents inconvénients.

Plus particulièrement, l'invention propose un composant optique pour le démultiplexage temporel de trains d'impulsions optiques, présentant une structure à multipuits quantiques et des moyens pour appliquer à une section de cette structure à multipuits quantiques une tension pour la commande de cette section comme porte optique de démultiplexage, caractérisé en ce qu'il comporte également des moyens pour appliquer une tension de polarisation à une autre section de cette structure à multipuits quantiques, cette section étant située sur le trajet des impulsions optiques en aval de la section utilisée comme porte optique, ces moyens de polarisation permettant de recueillir le photocourant généré par les impulsions optiques reçues par cette deuxième section, qui sert ainsi de photo-récepteur.

D'autres caractéristiques et avantages de ce composant ressortiront encore de la description qui suit. Cette description est purement illustrative et non limitative, elle doit être lue en regard des dessins annexés sur lesquels :
- la figure 1 est une représentation schématique en coupe d'un composant de démultiplexage temporel optique conforme à un mode de réalisation possible pour l'invention ;
- les figures 2 à 4 illustrent le démultiplexage que permet de réaliser le composant de la figure 1, la figure 2 montrant un train d'impulsions reçu par ce composant, la figure 3 illustrant le signal électrique en sortie de ce composant, la figure 4 illustrant le diagramme de l'oeil obtenu pour un codage aléatoire du modulateur de ce composant.

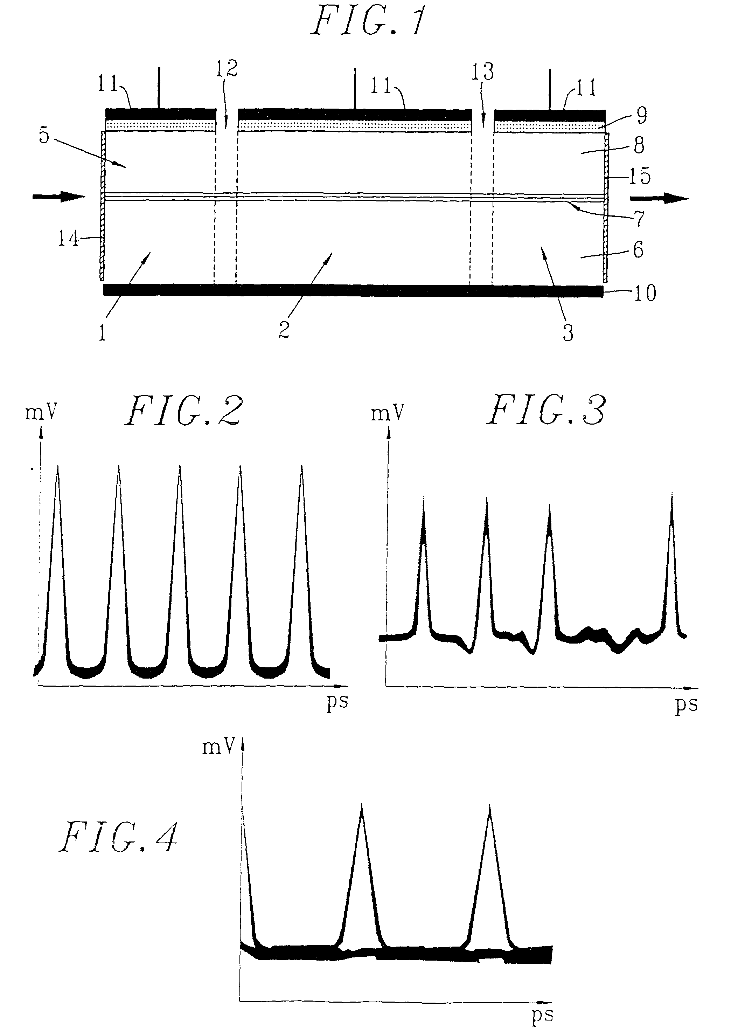

Le composant de démultiplexage optique temporel représenté sur la figure 1 est un composant monolithique intégrant une porte optique 1, un amplificateur 2 et une photodiode 3.

Ces trois fonctions sont réalisées par trois sections différentes d'une seule et même structure 5 à multipuits quantiques.

Les différentes couches de cette structure 5 sont réalisées par croissance sur un substrat 6 d'InP dopé n. Cette structure comporte en particulier un empilement 7 qui est constitué de treize empilements élémentaires comportant chacun une couche d'InGaAsP de 12 nm d'épaisseur formant puits quantique (λₚ₁ = 1,57 µm, où λₚ₁ est la longueur d'onde de transmission de la couche) et une couche d'InGaAsP de 6 nm d'épaisseur formant barrière quantique (λₚ₁ = 1,15 µm).

Cet empilement 7 est interposé entre deux couches de confinement optique de 30 nm d'épaisseur.

Sur la couche de confinement optique supérieure est déposée une couche 8 d'InP dopé p de 1,5 µm d'épaisseur, qui porte elle-même une couche 9 d'InGaAs dopé p de 0,12 µm d'épaisseur. Cette couche 9 constitue la couche de contact de la structure.

Sur l'empilement ainsi réalisé sur le substrat 6, on grave, par attaque chimique et gravure sèche, des rubans formant guides d'onde de 3 µm de largeur dont les flancs sont perpendiculaires au substrat 6. La surface supérieure de la structure obtenue est planifié par un dépôt de polyimide de part et d'autre de ces rubans.

On dépose ensuite sur la couche de contact 9 et le dépôt de polyimide - au droit de chacune des trois sections actives 1 à 3 du composant - une électrode 11 faiblement capacitive.

Sur sa surface opposée, le substrat 6 est également recouvert d'une couche de contact 10, qui est reliée au neutre.

La longueur de la section 1 utilisée comme porte optique est de 136 µm ; celle de la section 2 utilisée comme section d'amplification est de 500 µm ; celle de la section 3 utilisée comme photodiode est de 100 µm.

Conformément à un aspect avantageux, les différentes sections 1 à 3 de la structure à puits quantiques sont isolées électriquement par des séparations transversales 12 et 13 définissant des résistances d'isolation supérieures à 10 MΩ entre la section 2 intermédiaire d'amplification d'une part et les sections 1 et 3 qui constituent la porte optique et photodiode d'autre part. Ces résistances d'isolation 12 et 13 sont réalisées par des implantations de protons, par exemple d'ions H+, bombardés dans la couche 8 d'InP dopé p, sur des largeurs de 10 micromètres.

Des couches anti-reflet 14 et 15 sont déposées sur les faces d'entrée et de sortie du composant ainsi réalisé.

Le sens d'entrée/sortie des impulsions optiques dans le composant qui vient d'être décrit est illustré deux flèches sur la figure 1.

L'électrode 11 de la section 1 utilisée comme porte optique est commandée, de façon connue en soi pour un modulateur électro-absorbant, soit par un signal électrique en créneaux, soit par un signal électrique impulsionnel ayant un rapport cyclique suffisant par rapport au degré de démultiplexage désiré, soit encore par une tension sinusoïdale polarisée.

Typiquement, un tel modulateur permet de démultiplexer des trains d'impulsions présentant des débits allant jusqu'à 100 Gbit/s.

Pour utiliser la section 3 comme photodiode de réception, on la polarise par une tension de polarisation de l'ordre de -2V appliquée à son électrode 11. Chaque impulsion optique reçue par la section 3 est transformée en une impulsion de photocourant.

On injecte dans la section 2, par l'intermédiaire de son électrode 11, un courant de polarisation qui commande l'amplification dans cette section. L'amplification ainsi réalisée permet de compenser les pertes de couplage entre l'entrée du composant et la sortie de la fibre lui transmettant le train d'impulsions à démultiplexer.

On notera également que cette section amplificatrice 2 constitue une séparation entre la porte optique 1 et la photodiode 3 et permet de réduire fortement les interactions électriques à haute fréquence entre les voies de commande (électrodes 11) de ces deux sections.

On se réfère maintenant aux figures 2 à 4 sur lesquelles on a illustré une détection par un composant de démultiplexage du type de celui de la figure 1.

Les signaux optiques reçus en entrée du composant sont du type de ceux de la figure 2.

La section 1 formant modulateur électro-absorbant est commandé par un signal de type NRZ, polarisé à - 0,785 V, avec une amplitude de 2 V crête à crête.

Le courant de commande de la section d'amplification 2 est de 110 mA.

La tension de polarisation de la section 3 formant photodiode est de - 2,5 V.

Le train d'impulsions reçu est généré par un laser à 10 Gbit/s avec une largeur d'impulsion de 30 ps.

Un codage que permet de réaliser la porte optique 1 a été illustré sur la figure 3.

Sur la figure 4, on a représenté le diagramme de l'oeil obtenu pour un codage aléatoire sur le modulateur 1 à un débit de 10 Gbit/s. On notera que l'oeil y est très ouvert.

D'autres variantes de l'invention sont bien entendu envisageables. En particulier, la section amplificatrice peut être supprimée. Elle peut également être disposée avant la porte optique de façon à réduire l'influence du bruit liée à l'émission spontanée dans l'amplificateur sur la réception que réalise la section formant photodiode.

Comme on l'aura compris, le composant qui vient d'être décrit peut être intégré avec d'autres composants de démultiplexage présentant des structures à multipuits quantiques identiques sur un même composant monolithique.

L'invention trouve avantageusement application pour le démultiplexage de trains d'impulsions optiques de débits supérieurs à 10 Gbits/s, de préférence supérieurs à 20Gbits/s, et en particulier pour le démultiplexage d'impulsions solitons.

## Revendications

1. Composant optique pour le démultiplexage temporel de trains d'impulsions optiques, présentant une structure (7) à multipuits quantiques et des moyens (10, 11) pour appliquer à une section (1) de cette structure (7) à multipuits quantiques une tension pour la commande de cette section comme porte optique de démultiplexage, caractérisé en ce qu'il comporte également des moyens (10, 11) pour appliquer une tension de polarisation à une autre section (3) de cette structure (7) à multipuits quantiques, cette section (3) étant située sur le trajet des impulsions optiques en aval de la section utilisée comme porte optique, ces moyens de polarisation (10, 11) permettant de recueillir le photocourant généré par les impulsions optiques reçues par cette deuxième section (3), qui sert ainsi de photo-récepteur.

2. Composant selon la revendication 1, caractérisé en ce qu'il comporte en outre des moyens (10, 11) pour injecter un courant de polarisation dans une troisième section (2) de cette structure (7) à multipuits quantiques, cette troisième section (2) étant située sur le trajet des impulsions optiques, en amont de la section (2) utilisée comme photo-récepteur et servant ainsi d'amplificateur optique.

3. Composant selon la revendication 2, caractérisé en ce que la troisième section (2) est une section intermédiaire entre la section (1) utilisée comme porte optique et la section (3) utilisée comme photo-récepteur.

4. Composant selon l'une des revendications précédentes, caractérisé en ce qu'il présente des séparations électriques (12, 13) entre les différentes sections (1 à 3) de sa structure (7) à multipuits quantiques.

5. Composant selon la revendication 4, dont la structure (7) à multipuits quantiques est constituée d'une pluralité d'empilements élémentaires de puits et barrières quantiques entre une couche (6) dopée n et une couche (8) dopée p, caractérisé en ce que les séparations électriques (12, 13) sont constituées par des implantations de protons dans la couche dopée p.

6. Composant selon l'une des revendications précédentes, caractérisé en ce que la structure (7) à multipuits quantiques est constituée d'une pluralité d'empilements élémentaires de puits et barrières quantique d'AlGaAsP entre un substrat d'InP dopé n et une couche d'InP dopée p.

7. Composant monolithique intégrant plusieurs composants selon l'une des revendications précédentes, caractérisé en ce que leurs structures (7) à multipuits quantiques sont identiques.

8. Utilisation d'un composant selon l'une des revendications précédentes pour le démultiplexage de trains d'impulsions optiques de débits supérieurs à 10 Gbits/s.

9. Utilisation d'un composant selon l'une des revendications 1 à 7 pour le démultiplexage de trains d'impulsions optiques d'impulsions de débits supérieurs à 20Gbits/s.

10. Utilisation d'un composant selon l'une des revendications 1 à 7 pour le démultiplexage d'impulsions solitons.
